Europäisches Patentamt

(19) European Patent Office

Office européen des brevets

(11) Publication number: **0 031 463**
**B1**

(12) **EUROPEAN PATENT SPECIFICATION**

(45) Date of publication of patent specification: **13.06.84**

(51) Int. Cl.³: **G 03 F 7/02, G 03 F 7/26**

(21) Application number: **80107372.7**

(22) Date of filing: **26.11.80**

(54) Process for depositing a pattern of material on a substrate and use of this process for forming a patterned mask structure on a semiconductor substrate.

(30) Priority: **26.12.79 US 106608**

(43) Date of publication of application:
**08.07.81 Bulletin 81/27**

(45) Publication of the grant of the patent:
**13.06.84 Bulletin 84/24**

(84) Designated Contracting States:
**DE FR GB**

(56) References cited:
US - A - 3 873 361
US - A - 4 004 044

IBM TECHNICAL DISCLOSURE BULLETIN,
volume 9, no. 4, September 1966 NEW YORK
(US) R.P. ESCH et al. "Obtaining evaporated
metal patterns on substrates", pages 348-349
IBM TECHNICAL DISCLOSURE BULLETIN,
volume 18, no. 5, October 1975 NEW YORK (US)
P.E. CARR et al. "Structure for lift-off mask
formation", page 1396

(73) Proprietor: **International Business Machines Corporation**
**Old Orchard Road**
**Armonk, N.Y. 10504 (US)**

(72) Inventor: **Carr, Timothy William**
**22 Kimball Drive**
**Poughkeepsie New York 12603 (US)**
Inventor: **Needham, Charles Davis**
**Thornacre Road**
**Wappingers Falls New York 12590 (US)**
Inventor: **Villetto, Robert Thomas, Jr.**
**12 Hasbrouck Drive**
**Poughkeepsie New York 12601 (US)**

(74) Representative: **Kreidler, Eva-Maria, Dr. rer. nat.**
**Schönaicher Strasse 220**
**D-7030 Böblingen (DE)**

(56) References cited:
IBM TECHNICAL DISCLOSURE BULLETIN,
volume 22, no. 9, February 1980 NEW YORK
(US) J. HAVAS et al. "Lift-off underlay with
improved crack resistance and thermal stability",
page 4037

## Description

The invention relates to a process for depositing a pattern of material on a substrate and use of this process for forming a patterned mask structure on a semiconductor substrate.

Lift-off methods for use in depositing thin films in the fabrication of integrated circuits, which avoid edge tearing of the films, are described in U.S. Patents No. 3,873,361 and 4,004,044. A non-photosensitive polymer material is first deposited on the substrate surface upon which the film pattern is to be formed. Preferred materials are originally photosensitive resists of the type described, for example, in U.S. Patent No. 3,201,239. Alkali soluble resins, such as phenol-formaldehyde novolak resins, are combined with radiation sensitive o-quinone diazide compounds in a weight ratio of 1:1 to 1:6 quinone to resin and preferably between 1:2 and 1:4. Such materials are commercially available, for example, the AZ 111 or AZ 11350 type resists available from the Shipley Company. The resist layer is deposited from a solvent solution, dried and then baked at an elevated temperature which renders the layer non-photosensitive. The advantage of using such materials, rather than an unsensitized polymer, is that is has been found that, when heated, the sensitizer acts to cross-link the resin so that the dimensional stability of the layer is improved. Without the presence of the sensitizer, the layer would flow and cause the resolution of the lift-off mask to deteriorate during the film deposition process.

Underlayers of adhesion promoters and/or release layers, which promote removal of the lift-off mask at the desired time, can be used under the polymer layer.

On top of the polymer layer is formed a masking material of, for example, metal or a transparent layer of a polydimethylsiloxane resin followed by a patternable organic resist layer in which openings are placed in a selected pattern utilizing lithographic techniques. Conforming openings are placed in the underlying polydimethylsiloxane resin material and the openings are extended through the underlying resist material by successive reactive ion etching steps to expose the substrate surface in the aforesaid selected pattern. The thin film to be deposited is then applied over the resulting structure; it is, thereby, deposited on the substrate in said openings. The final reactive ion etching step affords edges in the openings through the siloxane resin material layer which overhang the edges in the openings through the polymer layer affording easy lift-off of the unwanted areas of the deposited film when the polymer layer is totally removed by the application of a solvent.

One application of this technique is the formation of conductive metal patterns. A metal is blanket evaporated onto the mask and substrate so that solvent removal of the mask and overlying metal leaves the desired metal pattern in contact with the integrated circuit substrate surface.

This technique generally provides excellent results but in some circumstances, for example, when depositing metals such as tantalum on a number of substrates in a vacuum evaporator, sudden changes in pressure are found to occur in the evaporator. This impacts the yield, with respect to the electrical properties of the metal film and the adhesion of the film to the substrate, when attempting to form low barrier height Schottky barrier diodes by depositing tantalum directly onto a silicon surface.

We have discovered that such pressure changes are due to previously undetected outgassing of solvent from the polymer underlayer when the substrate temperature reaches about 160—180°C even though this layer has been baked at higher temperatures of about 230°C for an hour or so during the mask formation process. It was previously believed that all of the volatile material had been removed by this baking.

The object of the invention is to avoid such an outgassing of solvent from the polymer underlayer when the substrate temperature reaches the above given temperatures.

This object is achieved by a process for depositing a pattern of material on a substrate according to claim 1 which is characterized in that before the deposition of the layer of material the patterned mask structure is baked at a temperature of at least 160°C for at least 30 minutes.

By this additional baking step after the mask has been formed the outgassing from the polymer underlayer is avoided. Also, volatile resin decomposition products which have been found to contaminate the surface of the substrate and the metal layer are avoided. The result is an improved metal film and increased thruput, particularly when forming Schottky barrier diode contacts.

In accordance with this invention there is provided an improved thin layer deposition lift-off process which employs a polymer under layer containing from about 10 to 25 percent by weight of sensitizer and which includes a baking step after the lift-off mask has been formed and before material evaporation. The process for coating a pattern of material on a substrate includes the steps of:

(1) depositing on the substrate from a solvent solution a first resist layer comprising from about 75 to 90 percent by weight of a phenol-formaldehyde novolak resin and from about 10 to 25 percent by weight of the layer of an o-quinone diazide and baking the layer,

(2) depositing an intermediate masking layer on the resist layer,

(3) depositing a second radiation sensitive resist layer on the intermediate masking layer and baking the layer,

(4) removing portions of the second resist layer by imagewise exposing the layer and developing the layer,

(5) removing the exposed portions of the intermediate masking layer by reactive ion etching using, for example, a fluorine containing gas,

(6) removing the exposed portions of the first resist layer by reactive ion etching using, for example, an oxygen containing gas to form a patterned mask structure on the substrate,

(7) baking the structure at a temperature of at least about 160°C for at least about 30 minutes,

(8) Depositing a layer of material onto the structure and the substrate surface, and

(9) removing the structure and the overlying material from the substrate by contacting said structure with a solvent for the first resist layer to leave a pattern of material on the substrate surface.

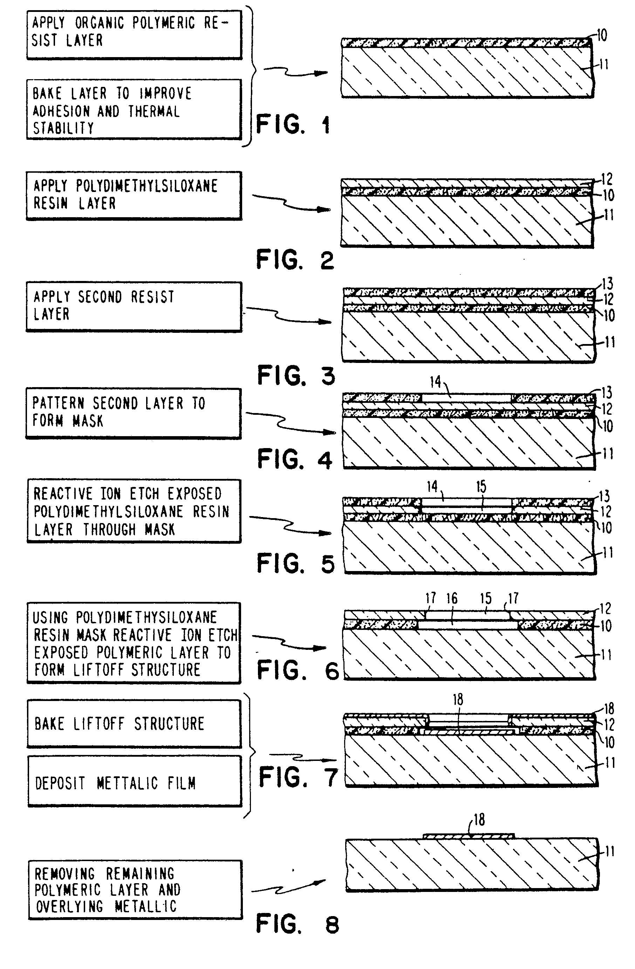

Figures 1—8 are a flow chart illustrating the steps of a preferred embodiment of the process of the invention along with diagrammatic cross-sectional views of a lift-off structure as successive steps during its formation.

The lift-off mask formation process is described in U.S. Patents No. 3,873,361 and 4,004,044 which are hereby incorporated by reference. Briefly, as illustrated in Figs. 1—6 an organic polymeric resist leyer 10 is applied to a substrate 11. The thickness of the resist film is chosen depending upon the thickness of the film to be evaporated onto the substrate as known in the art, for example, a resist film thickness of from about 1000 to 2500 nm. Prior to the application of the resist layer, various treatments of the substrate can be made in order to improve the adhesion/lift-off characteristics of the mask. For example, a thin (~200 nm) layer of a polysulfone such as a polymer prepared by reacting sulfur dioxide with aromatic or aliphatic vinyl compounds is coated from a solvent mixture of equal parts of diglyme and N-methyl pyrrolidone. The preferred polymer resist materials are mixtures of a phenol-formaldehyde novolak resin which contain a radiation sensitive o-quinone diazide. Such materials are described for example, in U.S. Patents 3,046,118; 3,046,121 and 3,201,239 which are incorporated by reference. Layer 10 is baked at an elevated temperature (210—230°C for 20 to 30 minutes) in order to remove the solvent and to cause the sensitizer to decompose and cross-link the layer so that the dimensional stability and adherence of the layer is improved. A resist layer containing at least about 10% by weight of sensitizer is needed for this purpose. On the other hand, we have found that amounts above about 25% and preferably 20% by weight based on the weight of resin and sensitizer, should be avoided as explained below.

Next as illustrated in Fig. 2, an intermediate masking layer of either a metal or preferably a polydimethyl siloxane resin material 12 is deposited on layer 10. The resin is spun-on to the surface of layer 10. Spinning speed is about 4,200 r.p.m. Material 12 preferably comprises a 150—160 nm thick film of Owens-Illinois type 650 resin dissolved in n-butyl acetate, 1 gram of resin to 10 milliliters of solvent. Polydimethylsiloxane material 12 is characterized by a preponderance of Si—O bonds relative to the number of Si—$CH_3$ bonds. The polydimethylsiloxane resin layer 12 is baked in a nitrogen ambient at about 230°C for about 30 minutes.

As set forth in Figs. 3 and 4, a layer of radiation sensitive resist such as photo or electron beam resist 13 is spun-on to the polydimethylsiloxane layer 12. For example, layer of Shipley AZ 1350 resist material is applied by spin coating and baked at 90°C for 30 minutes. A polymethyl methacrylate or polysulfone type resist material could also be used. HMDS 5 (hexamethyldisilazane) or A-1100 silane (available from Union Carbide Corporation) can be used for pretreatment of layer 12 to prepare it for AZ-type photoresist material 13. Openings such as opening 14 is produced in layer 13 by conventional lithographic techniques such as used in the integrated circuit fabrication art. It is to be noted that polydimethylsiloxane resin layer 12 is transparent, permitting the optical alignment of later applied mask patterns to the patterned surface of substrate 11.

The exposed and patterned layer 13 then is used as a mask for the reactive ion etching of polydimethylsiloxane resin layer 12 as shown in Fig. 5. The structure of Fig. 4 is placed into an RF sputter etching chamber such as described in U.S. Patent No. 3,598,710. The resin layer 12 is etched preferably with De-100 gas which is a fluorine-containing gas consisting of $CF_4$ and $O_2$ marketed by LFE Corporation. Thus, opening 14 in layer 13 is effectively transferred into resin layer 12 as opening 15. Resist layer 13 can be removed at this point by a suitable solvent. Alternatively it is removed during the subsequent reactive ion etching of layer 10 in oxygen.

Using polydimethylsiloxane mask 12 with openings 15 as shown in Fig. 6, the polymeric masking layer 10 is apertured by reactive ion etching in an oxygen gas ambient. The oxygen plasma is determined by the desired magnitude of the overhang 17 (in the opening 15 of layer 12) with respect to the opening 16 sputter-etched into polymeric layer 10. For example, a distinct overhang can be achieved at 40 millitorr oxygen pressure whereas substantially no overhang is produced when etching is done at 4 millitorr oxygen pressure (1 Torr = 133,3 Pa), The sucessive reactive ion etching steps undertaken in accordance with the steps associated with Figs. 5 and 6 are conveniently accomplished in the same reactive ion etching chamber utilizing first a fluorine-containing gas atmosphere (in the case of Fig. 5) followed by a purging and substitution of an oxygen gas ambient (in the case of Fig. 6).

The overhang 17 in resin layer 12 permits considerable "over etching" of the polymeric layer 10 to assure that all of the material of layer 10 has been removed in the locations of the desired opening 16. The pattern dimensions of the functional thin film material to be deposited on substrate 11 through openings 15 and 16 are determined by the overhang aperture size in layer 12 and not by the greater aperture size in layer 10. Additionally, the overhang 17 aids in the elimination of "edge tearing" when the thin film material is lifted off in subsequent steps of the present process.

According to prior practice, the mask is now ready for the deposition of a layer 18 of, for example metal such as aluminum, aluminumcopper, platinum, palladium, chromium, tantalum, etc. or an insulating layer of materials such as silicon dioxide or silicon nitride. It has been found, however, that in evaporating metal layers such as tantalum onto a bare silicon substrate for low barrier height Schottky barrier diode contact formation, sudden changes in pressure in the evaporator occur where a number of wafers are being coated at a time and the electrical properties of the Schottkys are impaired due to contamination of the tantalum so that yields are lowered. One possible solution would be to decrease the batch size but this lowers thruput. Also, even when running only one wafer at a time in the evaporator, the yield of useable product has been found to be comletely unsatisfactory.

We have discovered that the pressure changes are a result of the evolution of solvent and volatile resin decomposition products from the resist layer 10 portion of the lift-off mask even though this layer has been previously baked at a much higher temperature, for example, 230°C, during the mask formation process than the temperatures (160—180°C) to which it is heated during the metal deposition. It was previously believed that no significant amounts of solvent or other volatile materials would be evolved from layer 10 during the metal deposition step.

In accordance with the invention, we have found that the pressure changes are controlled by subjecting the lift-off mask shown in Fig. 6 to a baking step, Fig. 7 at a temperature of at least about 160° for at least about 30 minutes prior to the metal evaporation step. Higher temperatures can be used, for example, a range of 160 to about 200°C but temperatures which cause the mask to flow should be avoided. The baking can be done in a vacuum or an inert gas, such as $N_2$. This baking does not eliminate the outgassing but reduces it, and avoids sudden bursts of outgassing which previously occurred at temperatures near 175°C, to a degree where batches of least 10 wafers can be coated with metal in a vacuum evaporator with satisfactory electrical properties and adhesion of the metal film. The o-quinone diazide sensitizer in layer 10 also effects the electrical properties of deposited tantalum layers and we have found that amounts of above about 25% by weight should be avoided with a preferred range of about 10 to 20% by weight based on the total weight of novolak resin sensitizer. The axact reason for this is not known but the amount of sensitizer present is believed to effect the outgassing mechanism.

The pre-baking step also reduces resin decomposition during evaporation. These decomposition products are believed to deposit on the substrate surface and in the metal flim and also impact the contact properties and adhesion of tantalum films on bare silicon.

A metal film 18, for example, tantalum having a thickness of about 80 nm in thickness is next evaporated onto the lift-off mask, Fig. 7, and the lift-off mask and the overlying metal are removed by immersion in a solvent, such as, N-methyl pyrrolidone for about 15 to 30 minutes which leaves the film layer 18 in the desired pattern configuration of Fig. 8.

A composite metal film can be evaporated using the same lift-off mask. For example, after tantalum low barrier height Schottky barrier diode contact formation, an anti-migration layer of chromium is evaporated followed by a conductor metallurgy layer of aluminum/copper. The lift-off mask is then removed to leave the composite metal pattern.

The foregoing process permits the manufacture of tentalum low barrier Schottky diodes with acceptable yields and thruput which was not possible prior to our invention.

**Claims**

1. Process for depositing a pattern of material on a substrate where
a) on said substrate (11) from a solvent solution a first resist layer (10) is deposited comprising from 75 to 90 percent by weight of a phenolformaldehyde novolak resin and from 10 to 25 percent by weight o-quinone diazide sensitizer and said layer (10) is baked,
b) an intermediate masking layer (12) is deposited on said resist layer (10),
c) a second radiation sensitive resist layer (13) is deposited on the intermediate masking layer (12) and said layer (13) is baked,
d) portions (14) of said second resist layer (13) are removed by imagewise exposing and developing said layer (13),
e) the exposed portions (15) of the intermediate masking layer (12) are removed by reactive ion etching,
f) the exposed portions (16) of the first resist layer (10) are removed by reactive ion etching to form a patterned mask structure on the substrate,
g) a layer of material (18) is deposited onto said structure and said substrate surface, and
h) the structure and the overlying material are removed from the substrate by contacting said structure with a solvent for said first resist layer (10) to leave a pattern of material on the substrate surface characterized in that before the deposition of the material layer (18) the patterned mask structure is baked at a temperature of at least 160°C for at least 30 minutes.

2. Process of claim 1 where as substrate (11) a silicon semiconductor wafer is used and in step (g) a layer (18) of tantalum is deposited by evaporation onto the structure and the silicon surface to form a Schottky barrier diode contact.

3. Process of claim 1 where as intermediate masking layer (12) a transparent layer of polydimethylsiloxane resin material having a preponderance of Si—O bonds relative to the number of Si—CH₃ bonds is used and said layer is baked.

4. Process of claims 1 and 3 where the reactive ion etching of the intermediate masking layer (12) is accomplished in a fluorine containing gas and the reactive ion etching of the first resist layer (10) in an oxygen containing gas.

5. Process of claim 1 where as second radiation sensitive resist material (13) a photoresist or an electron beam resist is used.

6. Use of the process of one or several of the preceding claims for forming a patterned mask structure on a semiconductor substrate.

## Revendications

1. Procédé pour déposer un matériau sous forme de configuration sur un substrat, dans lequel il y a

a) dépôt sur le substrat 11 à partir d'une solution de solvant, d'une première couche de matériau de résist (10) comprenant environ 75 à 90 pour cent en poids d'une résine phénol-formaldéhyde du type novolaque et environ 10 à 25 pour cent en poids du sensibilisateur o-quinone diazide, et cuisson de ladite couche 10,

b) dépôt d'une couche de masquage intermédiaire (12) sur ladite couche de résist (10),

c) dépôt d'une seconde couche de résist sensible aux radiations (13) sur la couche de masquage intermédiaire (12), et cuisson de ladite couche (13).

d) suppression des portions (14) de la seconde couche de résist (13) par exposition de la configuration requise de la couche, et développement de ladite couche (13),

e) suppression de portions exposées (15) de la couche de masquage intermédiaire (12) par décapage des ions réactifs,

f) suppression des portions exposées (16) de la première couche de résist par décapage par ions réactifs afin de former une structure de masque sur le substrat,

g) dépôt d'une couche de matériau (18) sur ladite structure et sur ladite surface du substrat,

h) suppression de la structure et du matériau de revêtement du substrat en mettant en contact ladite structure avec un solvant de ladite première couche de résist (10) afin de laisser une configuration de matériau sur la surface du substrat, caractérisé en ce que, avant le dépôt de la couche de matériau (18) le structure du masque est cuite à une température d'au moins 160°C pendant au moins 30 minutes.

2. Procédé selon la revendication 1, dans lequel il est fait usage comme substrat (11) d'une pastille semiconductrice de silicium et dans lequel durant l'étape (g) il y a dépôt d'une couche de tantale (18) par évaporation sur la structure et la surface de silicium afin de former un contact de diodes à barrière de schottky.

3. Procédé selon la revendication 1, dans lequel il est fait usage comme couche de masquage intermédiaire (12) d'une couche transparente de résine polydiméthyl-siloxane ayant une prépondérance de liaisons Si—O par rapport au nombre de liaisons Si—CH₃, et cuisson de ladite couche.

4. Procédé selon les revendications 1 et 3, dans lequel il y a décapage par ions réactifs de la couche de masquage intermédiaire (12) dans un gaz contenant de la fluorine et décapage par ions réactifs de la première couche de résist (10) dans un gaz contenant de l'oxygène.

5. Procédé selon la revendication 1, dans lequel il est fait usage comme second matériau de résist sensible aux radiations (13) d'un matériau de photorésist ou d'un matériau sensible aux faisceaux d'électrons.

6. Utilisation du procédé selon l'une ou plusieurs des revendications précédentes pour former une structure de masque sur un substrat à semiconducteurs.

## Patentansprüche

1. Verfahren zum Aufbringen eines Musters aus einem Material auf einem Substrat, bei dem

a) auf dem Substrat (11) eine erste Resistschicht (10) aus einer Lösung aufgebracht wird, die 75 bis 90 Gew.% eines Phenol-Formaldehyd-Novolakharzes und 10 bis 25 Gew.% o-Chinondiazid-Sensibilisator enthält, und die Schicht (10) gehärtet wird,

b) eine Zwischenmaskierungsschicht (12) auf der Resistschicht (10) aufgebracht wird,

c) eine zweite strahlungsempfindliche Resistschicht (13) auf der Zwischenmaskierungsschicht (12) aufbebracht und die Schicht (13) gehärtet wird,

d) Teile (14) der zweiten Resistschicht (13) durch bildmäßiges Belichten und Entwickeln derselben entfernt werden,

e) die freigelegten Teile (15) der Zwischenmaskierungsschicht (12) durch reaktives Ionenätzen entfernt werden,

f) die freigelegten Teile (16) der ersten Resistschicht (10) durch reaktives Ionenätzen entfernt werden, um auf dem Substrat das Muster einer Maskenstruktur zu bilden,

g) eine Schicht (18) aus einem Material auf der Maskenstruktur und der Substratoberfäche aufgebracht wird, und

h) die Maskenstruktur und das darauf befindliche Material von dem Substrat entfernt werden, indem die Struktur einem Lösungsmittel für die erste Resistschicht (10) ausgesetzt wird, so daß auf dem Substrat ein Muster aus dem Material verbleibt, dadurch gekennzeichnet, daß vor dem Aufbringen der Materialschicht (18) das Muster der Maskenstruktur bei einer Temperatur von mindestens 160°C während mindestens 30 Minuten gehärtet wird.

2. Verfahren nach Anspruch 1, dadurch gekennzeichnet, daß als Substrat (11) ein Silicium-Halbleiterwafer verwendet wird und in Schritt g) eine Schicht (18) aus Tantal auf die Struktur und die Siliciumoberfläche aufgedampft wird, um einen Schottky-Kontakt zu bilden.

3. Verfahren nach Anspruch 1, dadurch gekennzeichnet, daß als Zwischenmaskierungsschicht (12) eine durchsichtige Schicht aus Polydimethylsiloxanharz, bei dem die Si-O-Bindungen relativ zu den Si—CH$_3$-Bindungen überwiegen, verwendet und die Schicht gehärtet wird.

4. Verfahren nach den Ansprüchen 1 und 3, dadurch gekennzeichnet, daß das reaktive Ionenätzen der Zwischenmaskierungsschicht (12) in einem fluorhaltigen Gas und das reaktive Ionenätzen der ersten Resistschicht (10) in einem sauerstoffhaltigen Gas ausgeführt wird.

5. Verfahren nach Anspruch 1, dadurch gekennzeichnet, daß als zweites strahlungsempfindliches Resistmaterial (13) ein Photoresist oder ein Elektronenstrahlresist verwendet wird.

6. Anwendung des Verfahrens nach einem oder mehreren der vorhergehenden Ansprüche zur Bildung eines Musters einer Maskenstruktur auf einem Halbleitersubstrat.

**FIG. 1**
APPLY ORGANIC POLYMERIC RE-SIST LAYER

BAKE LAYER TO IMPROVE ADHESION AND THERMAL STABILITY

**FIG. 2**
APPLY POLYDIMETHYLSILOXANE RESIN LAYER

**FIG. 3**
APPLY SECOND RESIST LAYER

**FIG. 4**
PATTERN SECOND LAYER TO FORM MASK

**FIG. 5**
REACTIVE ION ETCH EXPOSED POLYDIMETHYLSILOXANE RESIN LAYER THROUGH MASK

**FIG. 6**
USING POLYDIMETHYSILOXANE RESIN MASK REACTIVE ION ETCH EXPOSED POLYMERIC LAYER TO FORM LIFTOFF STRUCTURE

**FIG. 7**
BAKE LIFTOFF STRUCTURE

DEPOSIT METTALIC FILM

**FIG. 8**
REMOVING REMAINING POLYMERIC LAYER AND OVERLYING METALLIC